# FASCICULE DE BREVET EUROPEEN

(11) **EP 4 184 594 B1**
(45) Date de publication et mention de la délivrance du brevet: **31.01.2024**
(21) Numéro de dépôt: 22207393.4
(22) Date de dépôt: 15.11.2022
(51) Int. Cl.: H01L 31/105, H01L 31/103, H01L 31/028, H01L 31/18

(54) **PHOTODIODE GERMANIUM A COURANT D OBSCURITE REDUIT COMPORTANT UNE PORTION INTERMEDIAIRE PERIPHERIQUE A BASE DE SIGE/GE**
GERMANIUM-PHOTODIODE MIT REDUZIERTEM DUNKELSTROM MIT EINEM AUF SIGE/GE BASIERENDEN PERIPHEREN ZWISCHENTEIL
GERMANIUM PHOTODIODE WITH REDUCED DARK CURRENT COMPRISING A SIGE/GE-BASED PERIPHERAL INTERMEDIATE PORTION

(30) Priorité: 17.11.2021 FR 2112166
(43) Date de publication de la demande: 24.05.2023
(73) Titulaire: Commissariat à l'énergie atomique et aux énergies alternatives, 75015 Paris (FR)
(72) Inventeur: ALIANE, Abdelkader, 38054 GRENOBLE CEDEX 09 (FR); KAYA, Hacile, 38054 GRENOBLE CEDEX 09 (FR); HARTMANN, Jean-Michel, 38054 GRENOBLE CEDEX 09 (FR)
(74) Mandataire: INNOV-GROUP

(56) Documents cités:
- US-A1- 2020 168 758
- US-A1- 2020 176 503
- US-A1- 2021 104 644
- US-A1- 2021 111 205
- BENEDIKOVIC DANIEL ET AL: "Silicon-germanium receivers for short-wave-infrared optoelectronics and communications : High-speed silicon-germanium receivers (invited review)", NANOPHOTONICS, vol. 10, no. 3, 3 janvier 2021 (2021-01-03), pages 1059-1079, XP055897114, DE ISSN: 2192-8606, DOI: 10.1515/nanoph-2020-0547

## Description

### DOMAINE TECHNIQUE

Le domaine de l'invention est celui des photodiodes planaires à base de germanium. L'invention trouve une application notamment dans le domaine de la détection d'un rayonnement lumineux dans le proche infrarouge.

### ÉTAT DE LA TECHNIQUE ANTÉRIEURE

Les dispositifs optoélectroniques de photodétection peuvent comporter une matrice de photodiodes planaires passivées. Les photodiodes sont formées à partir d'une même couche semiconductrice à base de germanium qui s'étend suivant un plan principal, et présente deux faces opposées et parallèles entre elles. Elles comportent alors chacune une portion de détection, formée par exemple d'une première région en germanium dopé n+ et affleurant la première face, d'une deuxième région en germanium dopé p+ et affleurant la deuxième face, et d'une région intermédiaire en germanium intrinsèque ou très peu dopé p, et située entre les première et deuxième régions dopées. Une couche de passivation réalisée en un matériau diélectrique peut recouvrir la première face dans le but de limiter la contribution du courant d'obscurité au courant électrique mesuré par chaque photodiode.

La polarisation électrique de la première région dopée n+ et de la deuxième région dopée p+ peut être effectuée du côté de la première face. Ainsi, une portion latérale périphérique, par exemple réalisée en silicium polycristallin dopé p+, entoure la portion de détection dans un plan principal de la photodiode et vient au contact de la deuxième région dopée p+. Des contacts métalliques, disposés du côté de la première face, peuvent venir au contact de la première région dopée n+ et de la portion latérale périphérique dopée p+, et permettent de polariser en inverse la photodiode.

La première région dopée n+ peut être réalisée en dopant localement le germanium de la portion de détection, par exemple par implantation ionique de dopants de type n tels que le phosphore, l'arsenic ou l'antimoine. Il est alors généralement nécessaire de procéder à un recuit pour guérir au moins en partie les défauts cristallins générés dans le germanium par l'implantation ionique. Or, il apparaît que ces défauts cristallins restent difficiles à guérir, malgré un recuit à haute température. De plus, les recuits effectués lors du procédé de fabrication, tel que ce recuit à haute température, peuvent provoquer une diffusion importante et non contrôlée de ces dopants de la portion de diffusion. Cette diffusion des dopants de type n augmente le risque de court-circuit de la photodiode par la formation de zones de perçage reliant par exemple la première région dopée n+ et la portion latérale périphérique dopée p+. De plus, ces défauts cristallins générés par l'implantation ionique comme cette diffusion importante des dopants de type n contribuent à augmenter le courant d'obscurité et donc à dégrader les performances de la photodiode. Il existe donc un besoin de disposer d'une photodiode planaire dont le courant d'obscurité est réduit, notamment en ce qui concerne la part du courant d'obscurité liée à la réalisation de la première région dopée n+.

Les documents US 2020/176503 A1, US 2020/168758 A1, US 2021/104644 A1, US 2021/111205 A1, ainsi que l'article scientifique de Benedikovic et al. intitulé Silicon-germanium receivers for short-wave-infrared optoelectronics and communications, Nanophotonics, 2021, 10(3), 1059-1079, décrivent différents exemples de photodiodes planaires à base de germanium.

### EXPOSÉ DE L'INVENTION

L'invention a pour objectif de remédier au moins en partie aux inconvénients de l'art antérieur, et plus particulièrement de proposer une photodiode planaire présentant un courant d'obscurité réduit, en particulier la composante de surface de ce dernier au niveau de la première face de la photodiode.

Pour cela, l'objet de l'invention est une photodiode planaire comportant une couche principale présentant une première face et une deuxième face opposées l'une à l'autre et parallèles à un plan principal, réalisée en un premier matériau semiconducteur cristallin à base de germanium, comportant une portion de détection formée de : une première région dopée de type n et affleurant la première face, destinée à être polarisée électriquement ; une deuxième région dopée de type p et affleurant la deuxième face ; une région intermédiaire, située entre la première région dopée et la deuxième région dopée et entourant la première région dopée dans le plan principal. La photodiode planaire comporte également une portion latérale périphérique, réalisée en un deuxième matériau semiconducteur dopé de type p, entourant la portion de détection dans le plan principal, et venant au contact de la deuxième région dopée, et destinée à être polarisée électriquement.

Selon l'invention, la photodiode planaire comporte une portion intermédiaire périphérique, réalisée en une alternance de couches minces monocristallines de silicium germanium et de germanium, située au contact de la portion de détection au niveau de la première face, et s'étendant entre et à une distance non nulle de la première région dopée et de la portion latérale périphérique de manière à entourer la première région dopée dans le plan principal.

Certains aspects préférés mais non limitatifs de cette photodiode sont les suivants.

Les couches minces monocristallines de silicium germanium peuvent comporter une proportion atomique de silicium au moins égale à 70%.

Les couches minces monocristallines de silicium germanium et de germanium peuvent présenter chacune une épaisseur inférieure ou égale à 4nm.

La portion intermédiaire périphérique peut s'étendre dans une échancrure dite intermédiaire périphérique de la portion de détection située au niveau de la première face.

La photodiode planaire peut comporter une portion centrale réalisée en un second matériau semiconducteur cristallin dopé de type n, identique au premier matériau semiconducteur cristallin, située au contact de la portion de détection au niveau de la première face, et participant à former la première région dopée.

La photodiode planaire peut comporter une couche supérieure isolante recouvrant la portion de détection au niveau de la première face ainsi que la portion intermédiaire périphérique, et entourant latéralement une partie de la portion centrale qui fait saillie hors de la portion de détection.

La photodiode planaire peut comporter une portion supérieure située sur et au contact de la portion centrale, réalisée en un matériau semiconducteur cristallin dopé de type n.

La photodiode planaire peut comporter une portion supérieure située sur et au contact de la portion de détection, réalisée en un matériau semiconducteur cristallin dopé de type n.

La photodiode planaire peut comporter des contacts métalliques destinés à assurer la polarisation électrique de la photodiode, dont au moins un contact métallique central assurant la polarisation électrique de la première région dopée et au moins un contact métallique latéral venant au contact de la portion latérale périphérique.

La portion de détection peut être réalisée en germanium, et la portion latérale périphérique peut être réalisée à base de silicium.

L'invention porte également sur un procédé de fabrication d'au moins une photodiode planaire selon l'une quelconque des caractéristiques précédentes, comportant les étapes suivantes :
- réalisation d'un empilement comportant une première sous-couche destinée à former la deuxième région et une deuxième sous-couche destinée à former la région intermédiaire, recouvertes par une couche isolante supérieure
- réalisation de la portion latérale périphérique au travers de l'empilement pour déboucher sur la première sous-couche
- réalisation d'une échancrure intermédiaire périphérique dans la portion de détection au travers de la couche isolante supérieure et d'une partie de la deuxième sous-couche, entourant une zone destinée à former la première région dopée
- réalisation de la portion intermédiaire périphérique, dans l'échancrure intermédiaire périphérique, par épitaxie à partir de la deuxième sous-couche.

Le procédé de fabrication peut comporter l'étape suivante, postérieure à la réalisation de la portion intermédiaire périphérique :
- réalisation d'une échancrure centrale dans la portion de détection au travers de la couche isolante supérieure, entourée dans le plan principal par la portion intermédiaire périphérique
- réalisation d'une portion centrale réalisée en un second matériau semiconducteur cristallin identique au premier matériau semiconducteur cristallin, dans l'échancrure centrale, par épitaxie à partir de la deuxième sous-couche, et dopage de type n de la portion centrale à la croissance, la portion centrale participant ainsi à former la première région dopée.

L'échancrure centrale peut présenter une profondeur par rapport à un plan passant par la première face au plus égale à celle de l'échancrure intermédiaire périphérique.

Le procédé de fabrication peut comporter les étapes suivantes :
- réalisation d'une échancrure centrale dans la portion de détection au travers de la couche isolante supérieure et d'une partie de la deuxième sous-couche, entourée dans le plan principal par la portion intermédiaire périphérique ;
- réalisation d'une portion centrale réalisée en un second matériau semiconducteur cristallin identique au premier matériau semiconducteur cristallin, dans l'échancrure centrale, par épitaxie à partir de la deuxième sous-couche, le second matériau semiconducteur cristallin étant non intentionnellement dopé ;
- réalisation d'une portion supérieure sur et au contact de la portion centrale, en un matériau semiconducteur cristallin dopé de type n ;
- recuit de diffusion, de sorte que les dopants contenus dans la portion supérieure diffusent au travers de la portion centrale et dans une partie de la deuxième sous-couche pour participer à former la première région dopée.

Le procédé de fabrication peut comporter les étapes suivantes :
- réalisation d'une portion supérieure sur et au contact de la portion de détection, en un matériau semiconducteur cristallin dopé de type n ;
- recuit de diffusion, de sorte que les dopants contenus dans la portion supérieure diffusent dans une partie de la deuxième sous-couche pour former la première région dopée.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en coupe transversale et en vue de dessus, d'une photodiode planaire selon un mode de réalisation, où la première région dopée n+ est entourée d'une portion intermédiaire périphérique à base de SiGe/Ge monocristallins ;
la figure 1C est une vue schématique en coupe d'un exemple d'une portion intermédiaire périphérique à base de SiGe/Ge mono cristallins telle qu'illustrée sur la fig. 1A ;
les figures 2A à 2I illustrent différentes étapes d'un procédé de fabrication d'une photodiode planaire selon le mode de réalisation illustré sur la fig. 1A ;
les figures 3A et 3B sont des vues schématiques et partielles, en coupe transversale, d'une photodiode planaire selon des variantes de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte d'une manière générale sur une photodiode planaire, et de préférence sur une matrice de photodiodes, ainsi que sur un procédé de fabrication d'une telle photodiode. Chaque photodiode comporte une portion de détection réalisée à base de germanium, et est adaptée à détecter un rayonnement lumineux dans le proche infrarouge (SWIR, pour *Short Wavelength IR,* en anglais) correspondant à la gamme spectrale allant de 0.8µm à 1.7µm environ, voire à 2.5µm environ.

Chaque portion de détection des photodiodes est réalisée dans une même couche principale semiconductrice. Cette dernière s'étend dans un plan principal, et présente une première face et une deuxième face opposées l'une à l'autre et parallèles au plan principal. Les deux faces s'étendent donc suivant des plans identiques pour chacune des photodiodes, et délimitent verticalement (suivant l'axe d'épaisseur) la portion de détection.

Les photodiodes ne présentent pas une structure en mesa dans la mesure où elles sont réalisées à partir de la même couche principale semiconductrice et sont isolées optiquement les unes des autres par des tranchées latérales périphériques remplies par un matériau semiconducteur dopé. Elles présentent ainsi un facteur de remplissage particulièrement élevé. Par ailleurs, elles sont dites passivées dans la mesure où la surface de la première face est au moins en partie recouverte par une couche diélectrique de passivation. Celle-ci contribue à réduire la composante de surface du courant d'obscurité.

Le courant d'obscurité d'une photodiode est le courant électrique présent au sein de la photodiode en fonctionnement, lorsqu'elle n'est pas soumise à un rayonnement lumineux. Il peut être formé de courants générés thermiquement à l'intérieur du volume de la portion de détection (courants de diffusion, courants de déplétion, courants tunnels...) et de courants de surface. Les courants de surface peuvent être liés à la présence de charges électriques dans la couche diélectrique de passivation. En effet, ces charges électriques peuvent induire une modification de la courbure des bandes d'énergie à proximité de la surface, conduisant à la formation d'une zone déplétée ou d'une zone d'inversion. La zone déplétée, lorsqu'elle est située dans la zone de charge d'espace de la photodiode, peut donner lieu à des courants parasites de type génération-recombinaison. Par ailleurs, la zone d'inversion, alors électriquement conductrice, peut permettre le déplacement de charges électriques entre des régions polarisées dopées n et p et situées à l'interface avec la couche de passivation.

Dans le cadre de l'invention, la photodiode planaire comporte *a minima* :
- une portion de détection, réalisée dans une couche principale semiconductrice en un premier matériau semiconducteur cristallin à base de germanium, et comportant : une première région dopée de type n, une deuxième région dopée de type p, et une région intermédiaire située entre les deux régions dopées et entourant la première région dopée de type n dans le plan principal de la photodiode ;
- une portion latérale périphérique, réalisée en un deuxième matériau semiconducteur dopé de type p, entourant la portion de détection dans le plan principal et venant au contact de la deuxième région dopée de type p, et destinée à être polarisée électriquement ;
- une portion intermédiaire périphérique, réalisée en une alternance de couches minces monocristallines de silicium germanium et de germanium, entourant la première région dopée de type n dans le plan principal, au niveau de la première face, et située entre et à une distance non nulle de la première région dopée de type n et de la portion latérale périphérique dopée de type p.

Ainsi, comme décrit en détail plus loin, la portion intermédiaire périphérique formée d'une alternance de couches minces monocristallines en SiGe et de Ge participe à limiter la diffusion latérale non contrôlée des dopants de la première région dopée n+ en direction de la portion latérale périphérique dopée p+, et ainsi à réduire la composante de surface du courant d'obscurité.

Par ailleurs, de préférence, la première région dopée n+ est réalisée à partir d'une portion centrale dopée n+ en le premier matériau semiconducteur cristallin à base de germanium, épitaxié à partir d'une échancrure formée dans la portion de détection à partir de la première face, et dopée à la croissance (i.e. *in situ*) et non pas par implantation ionique. On réduit ainsi le nombre de défauts structurels dans le matériau épitaxié de la portion centrale comparé à la situation où le dopage serait réalisé par implantation ionique. On évite ainsi d'avoir recours à un recuit de guérison de défauts structuraux, qui induirait une diffusion importante et non contrôlée des dopants de la première région dopée n+. On réduit ainsi à nouveau la composante de surface du courant d'obscurité.

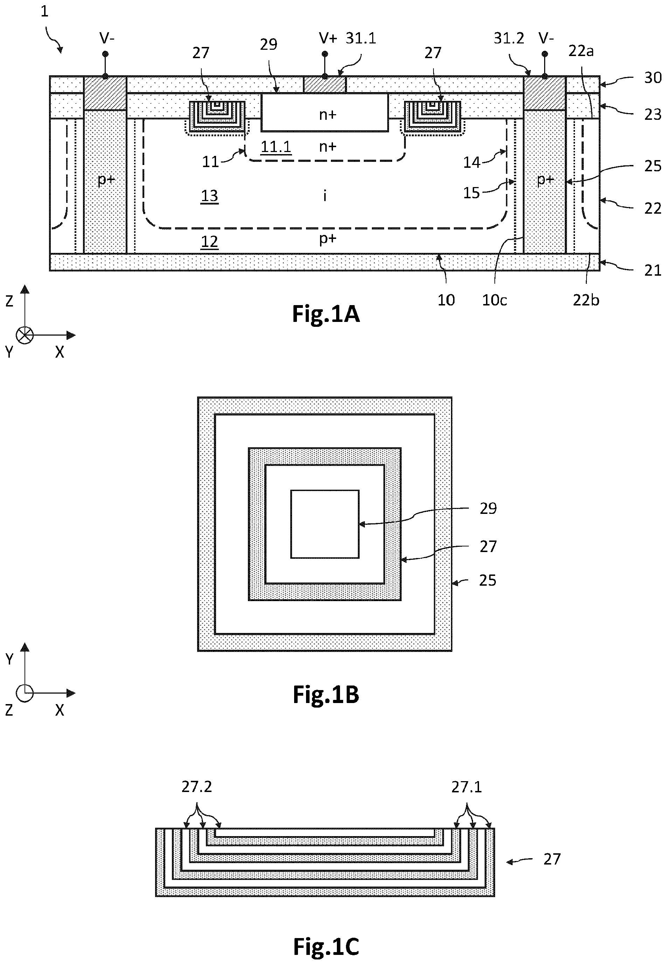

Les figures 1A et 1B sont des vues partielles et schématiques, en coupe et de dessus, d'une photodiode planaire 1 selon un mode de réalisation, appartenant à une matrice de photodiodes planaires identiques. De plus, la figure 1C est une vue schématique en coupe d'un exemple de portion intermédiaire périphérique 27 à base de SiGe et de Ge monocristallins.

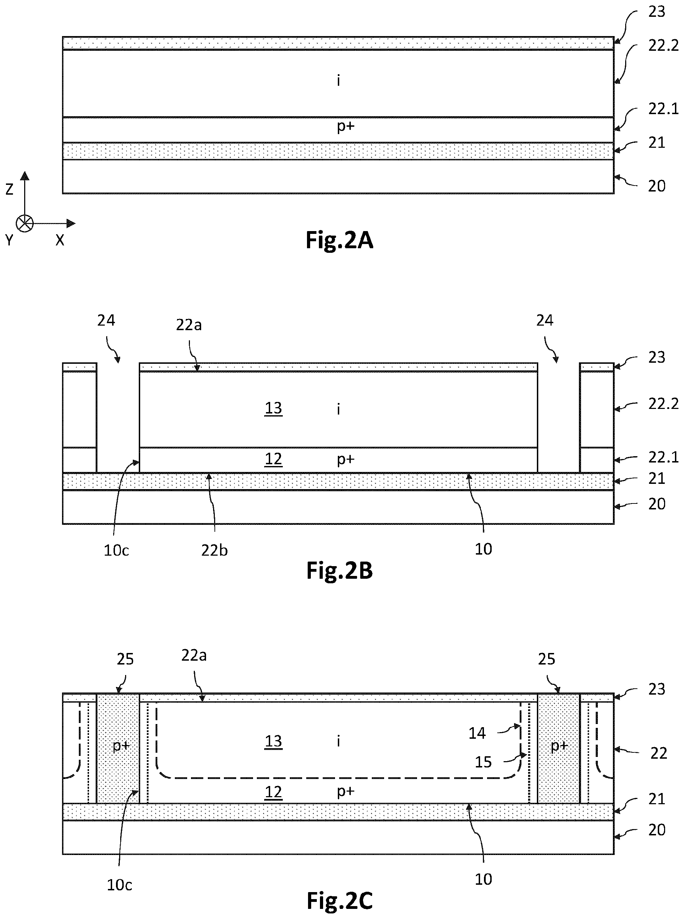

Les photodiodes 1 sont réalisées à base de germanium, et sont polarisées en inverse à partir de la première face 22a, tout en étant isolées les unes des autres par des tranchées latérales périphériques 24 remplies d'un matériau semiconducteur 25 dopé p+ (cf. fig.2B et 2C). Elles comportent chacune une portion intermédiaire périphérique 27 entourant la première région 11 dopée n+ au niveau de la première face 22a, et située entre et à distance entre la première région 11 dopée n+ et la portion latérale périphérique 25 dopée p+.

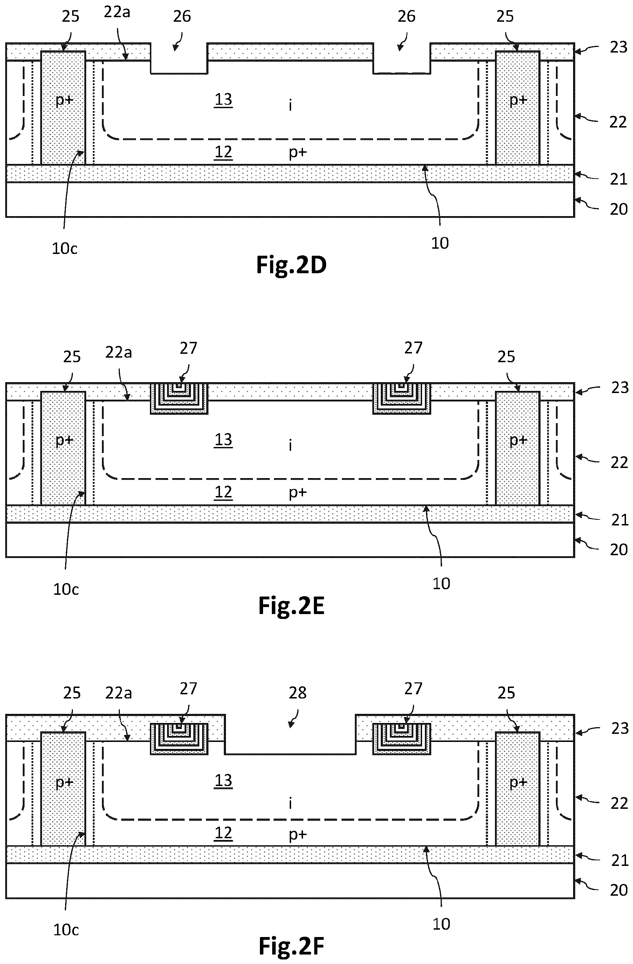

Par ailleurs, dans ce mode de réalisation, la première région 11 dopée n+ est avantageusement formée notamment d'une portion centrale 29 en germanium épitaxié à partir d'une échancrure centrale 28 formée dans la portion de détection 10 en germanium (cf. fig.2F), et dopé n+ lors de la croissance.

On définit ici et pour la suite de la description un repère direct tridimensionnel XYZ, où les axes X et Y forment un plan parallèle au plan principal de la photodiode 1, et où l'axe Z est orienté suivant l'épaisseur de la portion de détection 10 de la photodiode 1, à partir de la deuxième face 22b en direction de la première face 22a.

La photodiode 1 comporte une portion dite de détection 10 de la couche principale 22, s'étendant suivant l'axe Z entre une première et une deuxième faces 22a et 22b, parallèles entre elles et opposées l'une à l'autre. Les premières faces 22a des photodiodes sont coplanaires entre elles, et les deuxièmes faces 22b sont également coplanaires entre elles. La première face 22a est définie par une partie de la portion de détection 10 où affleurent la région intermédiaire 13. La deuxième face 22b est opposée à la première face 22a suivant l'axe Z.

L'épaisseur maximale de la portion de détection 10, définie suivant l'axe Z entre les première et deuxième faces 22a, 22b est ici sensiblement constante d'une photodiode 1 à l'autre, par exemple est comprise entre quelques centaines de nanomètres et quelques microns, par exemple entre 1µm et 5µm environ. L'épaisseur est choisie de manière à obtenir une bonne absorption dans la gamme de longueurs d'onde du rayonnement lumineux à détecter. La portion de détection 10 présente une dimension transversale dans le plan XY pouvant être comprise entre quelques centaines de nanomètres et quelques dizaines de microns, par exemple comprise entre 1µm et 20µm environ.

La portion de détection 10 est réalisée en un matériau semiconducteur cristallin, de préférence monocristallin, à base de germanium. Par « à base de germanium », on entend que le matériau semiconducteur cristallin correspond au germanium ou est un composé formé d'au moins le germanium. Ainsi, les photodiodes peuvent être réalisées, par exemple, en germanium Ge, en silicium germanium SiGe, en germanium étain GeSn, voire en silicium germanium étain SiGeSn. Dans cet exemple, la couche principale 22 et donc la portion de détection 10 sont réalisées en germanium. Elle peut ainsi être une couche ou un substrat réalisé en le même matériau semiconducteur et présenter des régions de différents types de conductivité (homojonction) de manière à former une jonction PN ou PIN. Elle peut en variante être un empilement de sous-couches de différents matériaux semiconducteurs (hétérojonction), lesquels sont alors formés à base de germanium.

La portion de détection 10 est ainsi formée d'une première région 11 dopée de type n (ici dopée n+), qui affleure la première face 22a et forme un caisson dopé n+, et une deuxième région 12 dopée de type p (ici dopée p+), qui affleure la deuxième face 22b. Par affleurer, on entend « arriver au niveau de », ou « s'étend à partir de ». Une région intermédiaire 13 non intentionnellement dopé (dans le cas d'une jonction PIN), ou dopée p (dans le cas d'une jonction PN), est située entre et au contact des deux régions dopées 11 et 12, et entoure la première région 11 dopée n+ dans le plan principal. Dans cet exemple, la jonction semiconductrice est de type PIN, la première région 11 étant dopée n+, la deuxième région 12 dopée p+ et la région intermédiaire 13 est intrinsèque (non intentionnellement dopée).

La première région 11 dopée n+ s'étend ici à partir de la première face 22a et est entourée par la région intrinsèque 13 dans le plan principal. Elle est distante de la bordure latérale 10c de la portion de détection 10 dans le plan XY, la bordure latérale 10c étant au contact de la face interne d'une portion latérale périphérique 25 dopée p+. Elle forme ainsi un caisson dopé n+ qui affleure la première face 22a et est espacée d'une distance non nulle vis-à-vis de la bordure latérale 10c ainsi que de la deuxième face 22b. La première région 11 dopée n+ participe ainsi à délimiter la première face 22a. Elle peut présenter un dopage pouvant être compris entre 5.10¹⁸ et 10²¹ at/cm³ environ.

La deuxième région 12 dopée p+ s'étend dans le plan XY en affleurant la deuxième face 22b, ici à partir de la bordure latérale 10c. Elle s'étend suivant l'axe Z à partir de la deuxième face 22b. Elle peut présenter une épaisseur sensiblement homogène suivant l'axe Z et ainsi affleurer uniquement une partie inférieure de la bordure latérale 10c. La deuxième région 12 dopée p+ peut présenter une région latérale 14 dopée p+ qui affleure continûment la bordure latérale 10c suivant l'axe Z et s'étend sur toute la périphérie de la portion de détection 10. La deuxième région 12 dopée p+ peut présenter un dopage pouvant être compris entre 10¹⁸ et 10¹⁹ at/cm³ environ.

La région intermédiaire 13 est située entre les deux régions 11, 12 dopées n+ et p+, et entoure la première région 11 dopée n+ dans le plan XY. Elle est ici réalisée en un matériau semiconducteur intrinsèque de manière à former une jonction PIN mais peut être faiblement dopée p, pour former une jonction PN.

La photodiode 1 comporte ici une couche isolante inférieure 21, réalisée en un matériau diélectrique, recouvrant la deuxième face 22b de la portion de détection 10, ainsi que, comme décrit plus loin, la face inférieure de la portion latérale périphérique 25 dopée p+. La couche isolante inférieure 21 peut en outre être adaptée à former une fonction d'antireflet vis-à-vis du rayonnement lumineux incident. Elle forme en effet la face de réception du rayonnement lumineux destiné à être détecté.

La portion de détection 10 de la photodiode 1 est ici délimitée latéralement, dans le plan XY, par une tranchée latérale périphérique 24, de préférence continue, remplie d'un matériau semiconducteur 25 dopé de type p, et formant une portion latérale périphérique 25, ici dopée p+. La portion latérale périphérique 25 participe à polariser électriquement la photodiode 1, ici à partir de la première face 22a, et à pixelliser la matrice de photodiodes (isolation optique). Elle s'étend ici sur toute l'épaisseur de la portion de détection 10 pour déboucher sur la couche isolante inférieure 21, mais en variante, elle peut ne pas déboucher sur la couche isolante inférieure 21 et peut se terminer dans la deuxième région 12 dopée p+. La face interne de cette portion latérale périphérique 25 dopée p+ est au contact de la bordure latérale 10c de la portion de détection 10. Le matériau semiconducteur est de préférence réalisé à base de silicium, par exemple du silicium amorphe, du silicium polycristallin, du silicium germanium, voire peut être réalisé en germanium amorphe.

Une couche isolante supérieure 23 recouvre la première face 22a de la photodiode 1, et permet d'isoler électriquement les contacts métalliques 31.1 et 31.2. Elle est ainsi au contact de la première région 11 dopée n+ ainsi que de la région intermédiaire 13. Elle est réalisée en un matériau diélectrique, tel qu'un oxyde de silicium, un nitrure de silicium, ou un oxynitrure de silicium. D'autres matériaux diélectriques peuvent être utilisés, tels qu'un oxyde d'hafnium ou d'aluminium, voire un nitrure d'aluminium, entre autres. Elle présente une épaisseur par exemple comprise entre 50nm et 500nm.

Par ailleurs, la portion de détection 10 comporte avantageusement une région latérale 14 dopée de type p située au niveau de la bordure latérale 10c. Cette région latérale 14 présente un niveau de dopage supérieur à celui de la région intermédiaire 13 lorsqu'elle est dopée. La région latérale 14 dopée p+ affleure la bordure latérale 10c et est au contact de la portion latérale périphérique 25 dopée p+. Ainsi, la polarisation de la deuxième région 12 dopée p+ est améliorée dans la mesure où la surface de contact avec la portion latérale périphérique 25 dopée p+ est augmentée. De plus, cette région latérale 14 dopée p+ permet d'éviter que la zone de charge d'espace de la photodiode 1 ne s'étende jusqu'à la bordure latérale 10c. Ainsi, on limite la contribution de cette zone (potentiellement non exempte de défauts liés à la réalisation des tranchées) au courant d'obscurité. On améliore ainsi les performances de la photodiode 1.

Par ailleurs, dans le cas comme ici où la portion de détection 10 est réalisée en germanium, et où la portion latérale périphérique 25 dopée p+ est réalisée en silicium, la portion de détection 10 comporte alors avantageusement une zone latérale 15 réalisée à base de silicium germanium. La zone latérale 15 affleure la bordure latérale 10c et est au contact de la portion latérale périphérique 25 dopée p+. Ainsi, la zone latérale 15 présente une énergie de bande interdite (gap) supérieure à celle de la portion de détection 10 réalisée en germanium. Cette « ouverture de gap » latérale permet de diminuer la sensibilité de la photodiode 1 aux défauts présents à proximité des tranchées 24. On améliore ainsi également les performances de la photodiode 1.

Dans ce mode de réalisation, la première région 11 dopée n+ est avantageusement formée d'une part d'une portion centrale 29 réalisée en germanium épitaxié dans une échancrure centrale 28 formée dans la portion de détection 10 et dopé n+ à la croissance, et d'autre part par une zone 11.1 dopée n+ adjacente à la portion centrale 29 et située dans la portion de détection 10.

La portion centrale 29 dopée n+ est donc située sur et au contact de la portion de détection 10 et s'étend à partir d'un plan passant par la première face 22a sur une profondeur non nulle par exemple de l'ordre de quelques centaines de nanomètres, par exemple 200nm. Elle est également ici en saillie au-dessus de ce plan suivant la direction +Z et est latéralement entourée et au contact de la couche supérieure isolante 23.

Le germanium de la portion centrale 29 dopée n+ est épitaxié localement à partir de la surface rendue libre du germanium de la portion de détection 10, dans l'échancrure centrale 28. La couche supérieure isolante 23 forme donc un masque de croissance. Le fait que la portion centrale 29 dopée n+ soit réalisée en le même matériau que celui de la portion de détection 10 fait qu'il y n'y a pas de désaccord du paramètre de maille. La qualité cristalline de la portion centrale 29 dopée n+ est donc très bonne, ce qui réduit le courant d'obscurité. A titre d'exemple, le taux de dislocations dans la portion centrale 29 dopée n+ peut être inférieur à 10³ dislocations/cm² dans la mesure où il n'y a pas de différence du paramètre de maille entre la portion centrale 29 en germanium dopé n+ et le germanium sous-jacent.

De plus, le germanium de la portion centrale 29 est dopé à la croissance et non pas par implantation ionique, ce qui contribue également à ce qu'il présente une bonne qualité cristalline, et donc contribue à réduire le courant d'obscurité. Il peut présenter un dopage en phosphore de l'ordre de 10¹⁸ à 10²⁰ cm⁻³. De plus, le fait que le germanium épitaxié soit dopé lors de la croissance et non par implantation ionique suivie d'un recuit de guérison des défauts cristallins permet de réduire la diffusion non contrôlée des dopants (par ex. du phosphore ou de l'arsenic, et de préférence du phosphore) dans la portion de détection 10, et ainsi de réduire le courant d'obscurité.

La taille dans le plan XY de la portion centrale 29 dopée n+ dépend de la taille de la photodiode 1 : pour une photodiode de 5µm de pas, elle peut être comprise entre 0.5 et 4µm environ (et de préférence inférieure à 2µm), et pour un pas de 10µm, elle peut être comprise entre 1 et 9µm environ.

Par ailleurs, la photodiode 1 comporte une portion intermédiaire périphérique 27, réalisée en une alternance de couches minces monocristallines de silicium germanium 27.1 et de germanium 27.2 (cf. fig.1C), et entourant la première région 11 dopée n+ dans le plan principal, au niveau de la première face 22a, et située entre et à une distance non nulle de la première région 11 dopée n+ et de la portion latérale périphérique 25 dopée p+.

La portion intermédiaire périphérique 27 s'étend donc suivant la direction -Z sur une profondeur non nulle de la portion de détection 10 à partir d'un plan passant par la première face 22a. Elle est également ici en saillie au-dessus de ce plan suivant la direction +Z et est au moins latéralement au contact de la couche isolante supérieure 23. Elle entoure la première région 11 dopée n+ dans le plan XY, de préférence entièrement, c'est-à-dire de manière continue, mais en variante, elle peut l'entourer de manière discontinue.

Elle est formée d'une pluralité de couches minces monocristallines de silicium germanium 27.1 et de germanium 27.2, réalisées les unes après les autres par épitaxie localisée dans une échancrure intermédiaire périphérique 26 réalisée au préalable dans la portion de détection 1 (cf. fig.2D). Elle présente une profondeur non nulle dans la portion de détection 10, à partir d'un plan passant par la face 22a, de préférence au moins égale à celle de la portion centrale 29 dopée n+, de manière à limiter la diffusion latérale des dopants de type n (ici le phosphore). A titre d'exemple, elle présente une profondeur de l'ordre de 200nm, et une dimension latérale dans le plan XY de l'ordre du micron.

Les couches minces 27.1 et 27.2 sont monocristallines. Pour cela, elles présentent une épaisseur inférieure ou égale à leur épaisseur critique à partir de laquelle les contraintes mécaniques relaxent de manière plastique (cf. par ex. la fig. 1C). Aussi, la portion intermédiaire périphérique 27 présente une bonne qualité cristalline qui limite la composante de surface du courant d'obscurité. La proportion atomique de silicium dans les couches minces 27.1 de SiGe est de préférence au moins égale à 70%, de manière à limiter efficacement la diffusion latérale des dopants de type n. Les couches minces de germanium 27.2 permettent de limiter les contraintes mécaniques et ainsi de préserver la qualité cristalline de la portion intermédiaire périphérique 27. De préférence, la portion intermédiaire périphérique 27 est formée d'un nombre entier de paires de couches minces 27.1 et 27.2 (moyennant la dernière couche mince réalisée), de manière à limiter les contraintes mécaniques.

La photodiode 1 comporte en outre des contacts métalliques 31.1, 31.2 permettant de la polariser en inverse à partir du côté de la première face 22a. Ainsi, un contact métallique 31.1 est ici disposé sur et au contact de la portion centrale 29, et permet de polariser électriquement la première région 11 dopée n+. Un contact métallique 31.2 est ici disposé sur et au contact de la portion latérale périphérique 25, et permet de polariser électriquement la deuxième région 12 dopée p+. Les contacts métalliques 31.1, 31.2 sont ici isolés électriquement les uns des autres dans le plan XY par la couche isolante supérieure 23 et par une couche diélectrique de passivation 30. La photodiode 1 est destinée à être polarisée en inverse, par exemple en appliquant un potentiel électrique négatif à la portion latérale périphérique 25 dopée p+ et en portant la première région 11 dopée n+ à la masse.

D'une manière générale, à titre illustratif, la photodiode 1 peut présenter des dimensions dans le plan XY comprises entre 1µm et 100µm environ. L'épaisseur de la deuxième région 12 dopée p+ peut être comprise entre 20nm et 500nm environ. L'épaisseur de la région intrinsèque 13 peut être comprise entre 0.7µm et 2.5µm environ lorsque la photodiode 1 est destinée à détecter un rayonnement lumineux dans la gamme du SWIR ou du proche infrarouge (NIR). La zone 11.1 de la première région 11 dopée n+ peut présenter une profondeur comprise entre 10nm et 600nm environ. Les couches diélectriques 23 et 30 peuvent présenter ensemble une épaisseur permettant de recouvrir entièrement la face supérieure de la photodiode 1, par exemple comprise entre 10nm et 600nm environ, et l'épaisseur de la couche isolante inférieure 21 peut être comprise entre 50nm et 1µm environ.

Ainsi, la photodiode 1 présente un courant d'obscurité réduit par la présence de la portion intermédiaire périphérique 27 à base de SiGe et de Ge mono cristallins qui limite la diffusion latérale des dopants de type n dans le plan XY à partir de la première région 11 dopée n+. De plus, dans la mesure où la première région 11 dopée n+ est avantageusement formée notamment de la portion centrale 29 en germanium qui est épitaxié à partir de la portion de détection 10 et qui est dopé n+ à la croissance, on améliore la qualité cristalline de cette région (absence de désaccord du paramètre de maille entre le matériau de la portion de détection 10 et celui de la portion centrale 29 dopée n+) et on limite alors le courant d'obscurité. Enfin, on limite également la diffusion non contrôlée des dopants de type n, ce qui contribue encore à réduire le courant d'obscurité.

Notons que des essais comparatifs ont été effectués pour comparer la qualité cristalline d'une portion centrale en germanium dopé de type n par implantation ionique, et celle de la portion centrale 29 en germanium dopé de type n à la croissance. Pour cela, des spectres Raman ont été obtenus, qui correspondent à l'évolution de l'intensité lumineuse d'un signal laser de 532nm de longueur d'onde diffusé par chaque portion centrale. Dans le premier cas, la portion centrale en germanium est dopée par implantation ionique de phosphore avec une dose de 3×10¹⁵ cm⁻² à 40keV suivie d'un recuit thermique rapide (RTA pour *Rapid Thermal Annealing*, en anglais) à 600°C pendant 60s sous azote. Le spectre Raman montre une position du pic de diffusion à 297.00 cm⁻¹ et une largeur à mi-hauteur de 5.97 cm⁻¹. En revanche, dans le second cas, la portion centrale en germanium est dopée à la croissance et n'est pas suivi d'un recuit. Le spectre Raman indique que le pic de diffusion se trouve à 300.56 cm⁻¹ avec une largeur à mi-hauteur de 3.15 cm⁻¹.

La comparaison des valeurs de largeur à mi-hauteur montre que le germanium dopé à la croissance présente une très bonne qualité cristalline comparée à celle du germanium dopé par implantation ionique. De plus, la comparaison des valeurs de position du pic montre que le germanium dopé par implantation ionique suivie du recuit est très fortement déformé en tension, contrairement au germanium dopé in situ, cette déformation en tension ayant un impact défavorable sur les performances de la photodiode 1 dans la mesure où cela provoque une diminution de l'énergie de bandes interdites du germanium, ce qui participe à augmenter le courant d'obscurité. Ainsi, la photodiode 1 avec la portion centrale 29 en germanium dopé à la croissance présente donc un courant d'obscurité réduit et donc de meilleures performances par rapport au cas du germanium dopé par implantation ionique.

Les figures 2A à 2I sont des vues schématiques et partielles, en coupe transversale, de différentes étapes d'un procédé de fabrication d'une photodiode selon l'exemple des fig.1A et 1B, comportant la portion intermédiaire périphérique 27 à base de SiGe et Ge monocristallins. Dans cet exemple, la première région 11 dopée n+ est réalisée à partir de la portion centrale 29 en germanium épitaxié et dopé n+ à la croissance.

Dans cet exemple, les photodiodes 1 sont réalisées en germanium et comportent une jonction PIN, et sont adaptées à détecter un rayonnement infrarouge dans la gamme SWIR. Les photodiodes 1 sont planaires et passivées, et sont polarisées en inverse à partir du côté de la première face 22a, et ici au moyen d'une puce de commande 40 hybridée à la matrice de photodiode 1.

En référence à la fig.2A, on réalise une première sous-couche semiconductrice 22.1 de germanium monocristallin. La première sous-couche semiconductrice 22.1 est solidarisée à une couche support 20, ici en silicium, par l'intermédiaire d'une couche isolante inférieure 21, ici en un oxyde de silicium. Cet empilement prend la forme d'un substrat GeOI (pour *Germanium On Insulator,* en anglais). Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une sous-couche semiconductrice de germanium 22.1 présentant une absence totale ou un faible taux de défauts structuraux tels que les dislocations. Le germanium peut être non intentionnellement dopé ou être dopé, par exemple de type p. La sous-couche semiconductrice 22.1 peut présenter une épaisseur comprise entre 100nm et 600nm environ, par exemple égale à 300nm environ, et peut être recouverte d'une couche de protection (non représentée) en un oxyde de silicium. La couche isolante inférieure 21 (BOX, pour *Buried Oxide*, en anglais) peut présenter une épaisseur comprise entre 50nm et 1µm, par exemple comprise entre 100nm et 500nm, et assure avantageusement une fonction d'antireflet. En variante, la structure initiale peut être de type Ge/Si formée d'une première sous-couche semiconductrice 22.1 de germanium épitaxié à partir de la couche support 20 en silicium, ou collé sur la couche support 20.

On réalise ensuite un dopage de la première sous-couche 22.1 en germanium dopé p+, par implantation ionique d'un dopant tel que le bore ou le gallium, lorsque la première sous-couche 22.1 était initialement en germanium intrinsèque. La couche de protection, le cas échéant, a été préalablement retirée par un nettoyage de surface, et la première sous-couche 22.1 de germanium peut être revêtue d'une couche d'oxyde de préimplantation (non représentée) d'une épaisseur de quelques dizaines de nanomètres, par exemple égale à 20nm. La sous-couche 22.1 de germanium présente alors un niveau de dopage compris entre 10¹⁸ et 10¹⁹ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. Ce recuit peut ne pas être effectué lorsque la sous-couche 22.1 était dopée à la croissance. Une autre manière de fabriquer cette couche 22.1 dopée p+ est par épitaxie d'une couche de germanium dopé en bore in situ entre 10¹⁸ et 10¹⁹ at/cm³ environ sur une sous-couche de germanium intrinsèque. Cette épitaxie peut se faire entre 400 et 800°C mais préférentiellement à 400°C.

On réalise une deuxième sous-couche semiconductrice 22.2 de germanium par épitaxie à partir de la première sous-couche 22.1. Les deux sous-couches 22.1, 22.2 sont destinées à former les portions de détection 10 coplanaires en germanium de la matrice de photodiodes 1. La deuxième sous-couche 22.2 est formée par épitaxie, par exemple par dépôt chimique en phase vapeur (CVD, pour *Chemical Vapor Deposition*, en anglais) et de précédence en pression réduite (RPCVD, pour *Reduced Pressure Chemical Vapor Deposition*) ou par toute autre technique d'épitaxie. Des recuits peuvent être effectués pour diminuer le taux de dislocations dans la sous-couche 22.2. La couche d'oxyde de préimplémentation, le cas échéant, a été préalablement retirée par un nettoyage de surface. La deuxième sous-couche 22.2 de germanium est ici intrinsèque, c'est-à-dire non intentionnellement dopée dans la mesure où l'on souhaite réaliser une jonction PIN. Elle est destinée à former la zone d'absorption lumineuse des photodiodes 1. Son épaisseur dépend de la gamme de longueurs d'onde du rayonnement lumineux à détecter dans le cas d'une photodiode 1. Dans le cadre de photodiodes SWIR, la sous-couche 22.2 de germanium intrinsèque présente une épaisseur par exemple comprise entre 0,5µm et 3µm, de préférence égale à 1µm.

On dépose ensuite une couche isolante supérieure 23 de manière à recouvrir continûment la face supérieure de la deuxième sous-couche 22.2, c'est-à-dire de manière à recouvrir les portions de détection 10 des photodiodes 1. La couche isolante supérieure 23 est réalisée en un matériau diélectrique, par exemple un oxyde, un nitrure ou un oxynitrure de silicium. Un nettoyage de la face supérieure de la deuxième sous-couche 22.2 peut avoir été effectué au préalable. La couche isolante supérieure 23 peut présenter une épaisseur comprise entre 10nm et 600nm.

En référence à la fig.2B, on réalise une tranchée latérale périphérique 24 destinée à pixelliser les photodiodes 1 et à participer à les polariser électriquement en inverse (au moyen des portions latérales périphériques 25 qui seront ensuite réalisées) à partir de la première face 22a. On réalise ainsi, par photolithographie et gravure, une gravure localisée de la couche isolante supérieure 23, de la sous-couche 22.2 de germanium intrinsèque, et de la sous-couche 22.1 de germanium dopé p+, jusqu'à déboucher ici sur la face supérieure de la couche isolante inférieure 21 (mais les tranchées latérales 24 peuvent déboucher sur la sous-couche 22.1 sans la traverser). Chaque tranchée latérale 24 s'étend ainsi de préférence continûment autour d'une photodiode 1. On obtient ainsi une pluralité de portions de détection 10 séparées les unes des autres par une tranchée latérale 24 continue. Elles sont obtenues de préférence par une technique de gravure anisotrope, de manière à obtenir une bordure latérale 10c sensiblement verticale suivant l'axe Z. Les tranchées latérales 24 présentent une dimension transversale (largeur) dans le plan XY pouvant être comprise entre 300nm et 2µm, par exemple égale à 1µm. Les portions de détection 10 peuvent ainsi présenter une forme dans le plan XY par exemple circulaire, ovale, polygonale, par exemple carrée, ou toute autre forme.

En référence à la fig.2C, on réalise ensuite les portions latérales périphériques 25 dopées de type p. Pour cela, on dépose un matériau semiconducteur dopé de manière à remplir chaque tranchée latérale 24. Le matériau semiconducteur est de préférence un matériau à base de silicium, par exemple du silicium amorphe, du silicium polycristallin, de silicium germanium, voire du germanium amorphe, déposé par épitaxie à une température comprise entre 500°C et 700°C par exemple. Le matériau semiconducteur est dopé p+ au bore ou au gallium, avec une concentration de dopants de l'ordre de 10¹⁹ à 10²⁰ at/cm³ environ. Ainsi, le matériau semiconducteur dopé vient au contact de la bordure latérale 10c par la tranchée latérale 24. Une étape de polissage mécanochimique (CMP) est ensuite effectuée, avec arrêt sur la face supérieure de la couche isolante supérieure 23, pour éliminer le matériau semiconducteur en excès et planariser la face supérieure formée par la couche isolante supérieure 23 et le matériau semiconducteur de la portion latérale périphérique 25. On obtient ainsi une portion latérale périphérique 25 dopée p+ dans chaque tranchée latérale 24. Un recuit est ensuite effectué pour assurer une passivation de la bordure latérale 10c de la portion de détection 10. Ce recuit assure une diffusion des dopants de type p à partir de la portion latérale périphérique 25 dans le germanium de la portion de détection 10, formant ainsi une région latérale 14 dopée p+. Ce recuit assure également une inter-diffusion du silicium de la portion latérale périphérique 25 dans la portion de détection 10, formant ainsi une zone latérale 15 de SiGe assurant une ouverture de gap. Ce recuit peut être effectué sous azote à une température comprise entre par exemple 600°C et 750°C, pendant une durée allant par exemple de 10min à 60min.

En référence à la fig.2D, on réalise ensuite une échancrure intermédiaire périphérique 26, destinée à la réalisation ensuite de la portion intermédiaire périphérique 27 à base de SiGe et de Ge monocristallins. Pour cela, on dépose tout d'abord une couche diélectrique de manière à recouvrir la surface supérieure des portions latérales périphériques 25 (on augmente ainsi l'épaisseur de la couche isolante supérieure 23 qui recouvre ainsi les portions latérales périphériques 25). Puis on réalise, par photolithographie et gravure, l'échancrure intermédiaire périphérique 26 au sein de la couche isolante supérieure 23 et de la portion de détection 10, en regard d'une zone périphérique située à distance dans le plan XY d'une part des portions latérales périphériques 25 et d'autre part d'une zone centrale destinée à former l'échancrure centrale 28. Elle peut présenter une largeur comprise entre 0.3µm et 5µm par exemple, et être par exemple égale à 1µm. L'échancrure intermédiaire périphérique 26 présente une profondeur non nulle au sein de la portion de détection 10, par exemple d'une à quelques centaines de nanomètres. De préférence, sa profondeur par rapport au plan de la première face 22a est au moins égale à celle de la portion centrale 29 de germanium dopé n+, de manière à limiter efficacement la diffusion latérale des dopants de la portion centrale 29.

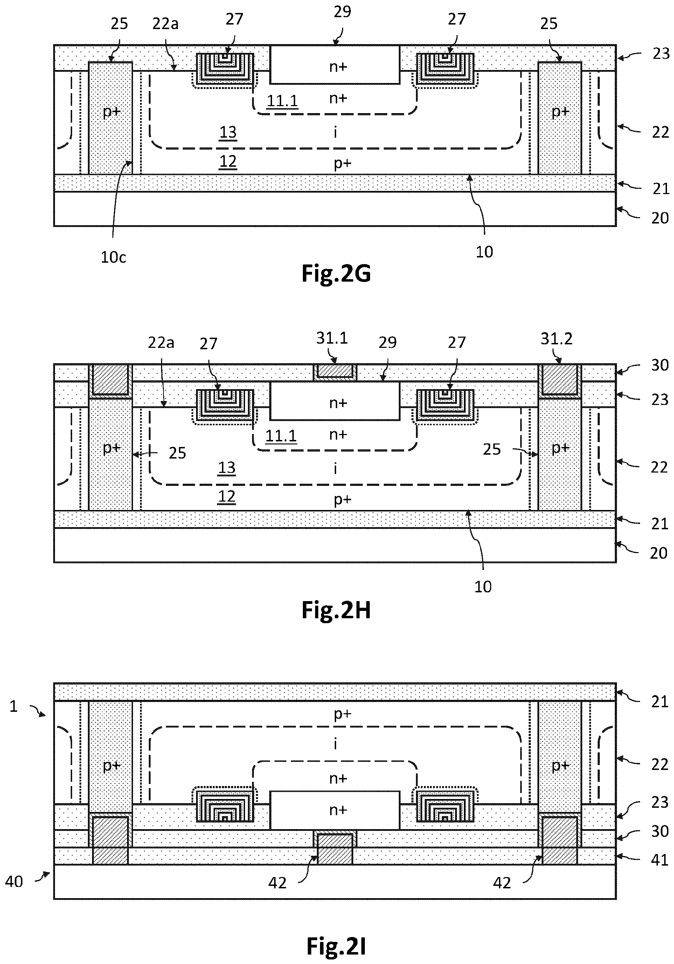

En référence à la fig.2E, on réalise ensuite la portion intermédiaire périphérique 27 à base d'une alternance de couches minces monocristallines de SiGe et de Ge. Ces couches minces sont réalisées par épitaxie localisée à partir de la surface libre de la portion de détection 10, i.e. à partir de la surface rendue libre du germanium de la portion de détection 10 dans l'échancrure intermédiaire périphérique 26. Ainsi, on réalise par épitaxie plusieurs périodes de paires formées d'une couche mince monocristalline de SiGe et d'une couche mince monocristalline de Ge. Le nombre de périodes dépend de la profondeur de l'échancrure intermédiaire périphérique 26, qui elle-même dépend de la profondeur ici de la portion centrale 29 de Ge dopé n+. Il peut être compris entre 2 et 100nm, voire davantage. Comme indiqué précédemment, les couches minces sont dites monocristallines dans la mesure où elles ne présentent pas de défauts structuraux tels que des dislocations. Pour cela, elles présentent une épaisseur inférieure à l'épaisseur critique à partir de laquelle les contraintes mécaniques relaxent de manière plastique (ce qui génère des défauts structuraux), de sorte que la portion intermédiaire périphérique 27 présente une très bonne qualité cristalline, réduisant ainsi la composante de surface du courant d'obscurité. Leur épaisseur est donc inférieure ou égale à 4nm environ, et peut être de l'ordre de 3nm environ. Le matériau de ces couches minces monocristallines n'est pas dopé intentionnellement de type n. En revanche, il peut être intrinsèque (non dopé intentionnellement), voire peut être dopé de type p (par exemple comme le matériau de la région intermédiaire 13). Ainsi, la portion intermédiaire périphérique 27 pourra limiter la diffusion latérale des dopants de type n de la première région 11 dopée n+, réduisant ainsi la composante de surface du courant d'obscurité. De préférence, chaque couche mince de SiGe comporte de préférence une proportion atomique d'au moins 70% de silicium, de manière à limiter efficacement la diffusion latérale des dopants provenant de la première région 11 dopée n+. Par ailleurs, la portion intermédiaire périphérique 27 pourra être entourée d'une zone d'inter-diffusion formée de SiGe (trait en pointillés à partir de la fig.2G) située dans la portion de détection 10, qui assure une ouverture de gap réduisant encore le courant d'obscurité. Cette zone d'inter-diffusion pourra être formée lors de la réalisation de la portion centrale 29 dopée n+ et de la première région 11 dopée n+.

En référence à la fig.2F, on réalise ensuite une échancrure centrale 28, destinée à la réalisation ensuite de la portion centrale 29 en germanium épitaxié et dopé n+ à la croissance. Pour cela, on dépose tout d'abord une couche diélectrique de manière à recouvrir la surface supérieure de la portion intermédiaire périphérique 27 (on augmente ainsi l'épaisseur de la couche isolante supérieure 23). Puis on réalise, par photolithographie et gravure, l'échancrure centrale 28 au sein de la couche isolante supérieure 23 et de la portion de détection 10, en regard d'une zone centrale située au centre de la portion de détection 10, entourée dans le plan XY par la portion intermédiaire périphérique 27. Elle peut présenter une largeur comprise entre 0.3µm et 5µm par exemple, par exemple égale à 2µm. L'échancrure centrale 28 présente une profondeur non nulle au sein de la portion de détection 10, de préférence au plus égale à celle de la portion intermédiaire périphérique 27 (par rapport au plan de la première face 22a), de manière à limiter efficacement la diffusion latérale des dopants provenant de la portion centrale 29 dopée n+.

En référence à la fig.2G, on réalise ensuite la portion centrale 29 en germanium dopé n+ par épitaxie localisée à partir de la surface libre de la portion de détection 10 située dans l'échancrure centrale 28. La portion centrale 29 peut être épitaxiée par dépôt chimique en phase vapeur à pression réduite (RPCVD, pour *Reduced Pressure Chemical Vapor Déposition* en anglais), par exemple à une température comprise entre 400°C et 800°C. La portion centrale 29 est réalisée en un matériau identique à celui de la portion de détection 10, donc ici en germanium. De plus, il est dopé de type n à la croissance (et donc non pas par implantation ionique), par exemple au phosphore ou à l'arsenic, de manière à présenter un dopage de l'ordre de 10¹⁸ à 10²⁰ cm⁻³. La portion centrale 29 remplit donc une épaisseur telle qu'elle remplit l'espace délimité par l'échancrure centrale 28, et peut faire saillie hors de la couche supérieure isolante 23. Une étape de polissage mécanochimique (CMP) est ensuite effectuée, avec arrêt sur la face supérieure de la couche isolante supérieure 23, pour éliminer le germanium en excès et planariser la face supérieure formée par la couche isolante supérieure 23 et le germanium de la portion centrale 29. La profondeur de la portion centrale 29 dans la portion de détection 10 peut être comprise entre 50nm et 1µm environ, et peut être de l'ordre de 200nm. Notons que, préalablement à l'étape d'épitaxie du germanium dopé n+, la surface libre du germanium de l'échancrure centrale 28 peut être nettoyée à l'acide fluorhydrique suivi d'un recuit sous H2 pour s'affranchir de la contamination résiduelle à l'oxygène, au carbone, et au fluor. Par ailleurs, un recuit d'activation des dopants peut être effectué ou non, en fonction de la température d'épitaxie de la portion centrale 29. Ainsi, à titre d'exemple, dans le cas d'une épitaxie à basse température (par ex. 400°C), une étape d'activation est prévue avec par exemple un recuit thermique rapide (RTA pour *Rapid Thermal Annealing,* en anglais) entre 500°C et 600°C pendant 10 à 30 sec. Dans le cas d'une épitaxie au-dessus de 600°C, il n'est pas nécessaire de rajouter cette étape de recuit car les dopants de type n sont déjà activés.

On obtient ainsi une portion centrale 29 en germanium dopé n+ présentant une bonne qualité cristalline, ce qui contribue à réduire le courant d'obscurité. Notons également que les dopants de type n de la portion centrale 29, à savoir ici le phosphore ou l'arsenic, diffusent dans le germanium de la portion de détection 10 lors de cette étape d'épitaxie. Aussi, on obtient une première région 11 dopée n+ formée d'une part de la portion centrale 29 en germanium épitaxié et dopé n+ in situ, et d'autre part de la zone 11.1 adjacente dopée n+. Notons enfin que la diffusion latérale dans le plan XY de ces dopants est fortement limitée par la présence de la portion intermédiaire périphérique 27 en SiGe et en Ge monocristallins, ce qui se traduit par une réduction de la composante de surface du courant d'obscurité.

En référence à la fig.2H, on réalise les contacts métalliques central 31.1 et latéral 31.2. Pour cela, on dépose tout d'abord une couche diélectrique de passivation 30 de manière à recouvrir la portion centrale 29. La couche diélectrique 30 peut être déposée à 400°C et être réalisée en un matériau diélectrique tel qu'un oxyde, nitrure ou oxynitrure de silicium, un oxyde ou nitrure d'aluminium, un oxyde d'hafnium, entre autres. Elle peut présenter une épaisseur comprise par exemple entre 200nm et 1000nm. Une étape de planarisation de type CMP est ensuite effectuée. On réalise ensuite des ouvertures traversantes au travers des couches diélectriques 23, 30 de manière à déboucher sur une surface supérieure de la portion centrale 29 et sur une surface supérieure de la portion intermédiaire périphérique 27. Enfin, on réalise les contacts métalliques central 31.1 et latéral 31.2. On dépose ici une couche mince d'accroche formée d'un empilement de type Ti/TiN/Cu par dépôt chimique en phase valeur dans les ouvertures traversantes, et on remplit l'espace vide par du cuivre déposé par électrolyse. Une étape de planarisation de type CMP est ensuite effectuée avec arrêt sur l'oxyde de la couche diélectrique de passivation 30. La couche diélectrique de passivation 30 et les contacts métalliques 31.1 et 31.2 présentent ensemble une même face supérieure planaire.

En référence à la fig.2I, on réalise l'hybridation de l'empilement optoélectronique ainsi obtenu sur une puce de commande 40. La face de connexion de la puce de commande 40 peut ainsi être revêtue d'une couche isolante 41, réalisée en un matériau diélectrique, traversée par des contacts métalliques 42. La matrice de photodiodes 1 et la puce de commande 40 sont ainsi assemblées par adhésion moléculaire hybride, par contact des faces formées des contacts métalliques et des couches isolantes. Un recuit de collage peut être effectué de manière à augmenter l'énergie de collage surfacique entre les deux faces en contact. On effectue ensuite la suppression de la couche support 20, par exemple par abrasion (*grinding,* en anglais), de manière à exposer la couche isolante inférieure 21. Celle-ci forme ainsi la face de réception du rayonnement lumineux à détecter, et assure avantageusement une fonction d'antireflet.

Ainsi, le procédé de fabrication permet d'obtenir une ou plusieurs photodiodes 1 passivées, comportant chacune une portion intermédiaire périphérique 27 située au niveau de la première face 22a et entourant la première région 11 dopée n+, permettant ainsi de limiter la diffusion latérale des dopants de type n provenant de la première région 11 dopée n+, et donc de réduire la composante de surface du courant d'obscurité. Le silicium de la portion 27 présente une grande énergie de bandes interdites, ce qui contribue à réduire le courant d'obscurité en surface. De plus, la première région 11 dopée n+ est ici avantageusement formée notamment de la portion centrale 29 en germanium épitaxié et dopé n+ in situ. Cette portion centrale 29 présente donc une très bonne qualité cristalline, ce qui réduit encore le courant d'obscurité, et on limite également la diffusion non contrôlée des dopants de type n. On réalise ainsi une ou plusieurs photodiodes 1 ayant des performances améliorées.

Selon une variante de réalisation, la portion centrale 29 dopée n+ peut être réalisée en un matériau cristallin différent de celui de la portion de détection 10. Il peut ainsi s'agir d'un matériau semiconducteur cristallin dopé n+, qui présente un paramètre de maille naturel égal à 1% près, et de préférence à 0.5% près, à celui du matériau semiconducteur cristallin de la portion de détection 10, ici du germanium, et présente une énergie de bandes interdites supérieure d'au moins 0.5eV à celui du matériau semiconducteur cristallin de la portion de détection 10 (germanium). La portion centrale 29 peut ainsi être réalisée en un composé binaire ou ternaire III-V, tel que du GaAs, AlAs, GaAlAs, GalnP, entre autres. L'absence de désaccord du paramètre de maille entre le matériau cristallin de la portion centrale 29 et celui de la portion de détection 10 permet d'éviter les défauts structuraux (dislocations...) qui viendraient dégrader les performances de la photodiode 1. De plus, le fait que l'énergie de bandes interdites soit supérieure à celle du germanium de la portion de détection 10 permet réduire le courant d'obscurité de la photodiode 1 d'une part, et de diminuer la sensibilité de la photodiode 1 vis-à-vis des défauts éventuellement présents à proximité de l'échancrure 28 dans laquelle est située la portion centrale 29.

Un exemple d'une telle portion centrale 29 est décrit dans la demande de brevet FR2101290 déposée le 11/02/2021. Elle peut être réalisée par épitaxie RPCVD ou par épitaxie par jets moléculaires (MBE pour *Molecular Beam Epitaxy*, en anglais). Par ailleurs, le dopage de type n de la portion centrale 29 est ici également réalisé à la croissance. A titre d'exemple, la portion centrale 29 est réalisée en AlAs ou en GaAs (composés stoechiométriques, c'est-à-dire que la proportion des deux éléments est identique, dont le paramètre de maille naturel est de 5.6605Â pour l'AlAs et de 5.653Â pour le GaAs, ce qui correspond respectivement à un écart de 0.044% et de 0.088% avec le paramètre de maille naturel de 5.658Â du germanium. De plus, l'énergie de bandes interdites est de 2.12eV pour l'AlAs et de 1.424eV pour le GaAs, ce qui est bien supérieur aux 0.67eV du germanium. D'autres composés semiconducteurs, par exemple ternaires, peuvent également convenir, comme par exemple le GaAlAs et le GaInP en fonction des proportions des différents éléments chimiques.

Selon une variante de réalisation, la portion centrale 29 n'est pas dopée à la croissance (ni par implantation ionique), mais son matériau lors de l'épitaxie est non intentionnellement dopé. Elle est alors dopée n+ dans un second temps, par diffusion de dopants de type n à partir d'une portion supérieure 32 dopée n+ et formant un réservoir de dopants. Un exemple d'une telle portion supérieure 32 est également décrit dans la demande de brevet FR2101290 déposée le 11/02/2021. Dans cette variante, la portion centrale 29 peut être réalisée en germanium ou en un composé binaire ou ternaire III-V, tel que du GaAs, AlAs, GaAlAs, GaInP, entre autres, épitaxié à partir du matériau cristallin de la portion de détection 10.

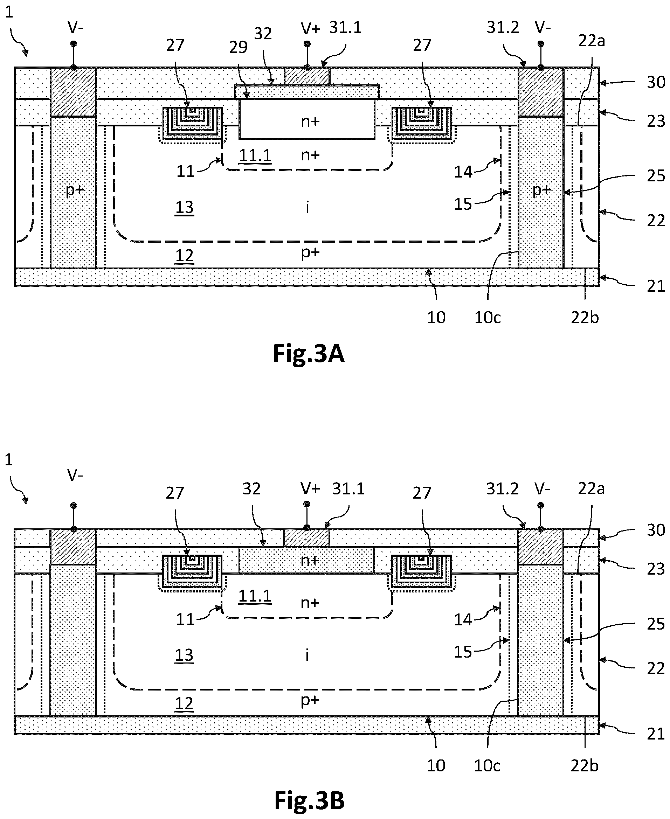

A ce titre, la figure 3A est une vue schématique et partielle, en coupe transversale, d'une photodiode planaire 1 selon une telle variante de réalisation. La photodiode 1 est similaire à celle de la fig. 1A, et s'en distingue essentiellement en ce qu'elle comporte une portion supérieure 32, qui repose sur et au contact de la portion centrale 29. Elle est espacée de la portion latérale périphérique 25 et des contacts métalliques 31.2 dans le plan XY d'une distance non nulle. Cet espacement latéral est rempli ici par la couche diélectrique de passivation 30. La portion supérieure 32 est réalisée en un matériau semiconducteur dopé n+, avec des dopants susceptibles de doper n+ la portion centrale 29 et une zone 11.1 de la portion de détection pour former la première région 11 dopée n+, ici avec du phosphore ou de l'arsenic. Ainsi, la portion supérieure 32 est un réservoir de dopants destinés à diffuser, lors d'un recuit de diffusion, au travers de la portion centrale 29 pour former la première région 11 dopée n+. Elle est de préférence réalisée à partir de silicium polycristallin, mais d'autres matériaux polycristallins peuvent bien entendu être utilisés.

Selon une autre variante de réalisation, la photodiode 1 ne comporte pas de portion centrale 29 épitaxiée à partir du germanium de la portion de détection 10 dans une échancrure centrale 28. La portion de détection 10 ne comporte donc pas d'échancrure centrale 28, mais seulement une échancrure périphérique intermédiaire dans laquelle est située la portion intermédiaire périphérique 27 à base de SiGe et de Ge monocristallins. La première région 11 dopée n+ est alors une zone 11.1 de la portion de détection 10 qui s'étend à partir de la première face 22a.

A ce titre, la figure 3B est une vue schématique et partielle, en coupe transversale, d'une photodiode planaire selon une telle variante de réalisation. La photodiode 1 est similaire à celle de la fig.3A, et s'en distingue essentiellement en ce qu'elle ne comporte pas de portion centrale 29, et en ce que la portion supérieure 32 repose sur et au contact de la portion de détection 10. Elle est espacée de la portion latérale périphérique 25 et des contacts métalliques 31.2 dans le plan XY d'une distance non nulle. Cet espacement latéral est rempli ici par la couche supérieure isolante 23. La portion supérieure 32 est réalisée en un matériau semiconducteur dopé n+, avec des dopants susceptibles de doper n+ une zone 11.1 de la portion de détection 10 pour former la première région 11 dopée n+, ici avec du phosphore ou de l'arsenic. Ainsi, ici aussi, la portion supérieure 32 est un réservoir de dopants destinés à diffuser, lors d'un recuit de diffusion, au travers de la portion centrale 29 pour former la première région 11 dopée n+. Elle est de préférence réalisée à partir de silicium polycristallin, mais d'autres matériaux polycristallins peuvent bien entendu être utilisés.

Des modes de réalisation particuliers viennent d'être décrits. Différentes variantes et modifications apparaîtront à l'homme du métier.

## Revendications

1. Photodiode planaire (1), comportant :
o une couche principale (22) présentant une première face (22a) et une deuxième face (22b) opposées l'une à l'autre et parallèles à un plan principal, réalisée en un premier matériau semiconducteur cristallin à base de germanium, comportant une portion de détection (10) formée de :
• une première région (11) dopée de type n et affleurant la première face (22a), destinée à être polarisée électriquement ;
• une deuxième région (12) dopée de type p et affleurant la deuxième face (22b) ;
• une région intermédiaire (13), située entre la première région dopée (11) et la deuxième région dopée (12) et entourant la première région dopée (11) dans le plan principal ;
o une portion latérale périphérique (25), réalisée en un deuxième matériau semiconducteur dopé de type p, entourant la portion de détection (10) dans le plan principal, et venant au contact de la deuxième région dopée (12), et destinée à être polarisée électriquement ;
o **caractérisé en ce qu'**elle comporte :
o une portion intermédiaire périphérique (27), réalisée en une alternance de couches minces monocristallines de silicium germanium (27.1) et de germanium (27.2), située au contact de la portion de détection (10) au niveau de la première face (22a), et s'étendant entre et à une distance non nulle de la première région dopée (11) et de la portion latérale périphérique (25) de manière à entourer la première région dopée (11) dans le plan principal.

2. Photodiode planaire (1) selon la revendication 1, dans laquelle les couches minces monocristallines de silicium germanium (27.1) comportent une proportion atomique de silicium au moins égale à 70%.

3. Photodiode planaire (1) selon la revendication 1 ou 2, dans laquelle les couches minces monocristallines de silicium germanium (27.1) et de germanium (27.2) présentent chacune une épaisseur inférieure ou égale à 4nm.

4. Photodiode planaire (1) selon l'une quelconque des revendications 1 à 3, dans laquelle la portion intermédiaire périphérique (27) s'étend dans une échancrure dite intermédiaire périphérique (26) de la portion de détection (10) située au niveau de la première face (22a).

5. Photodiode planaire (1) selon l'une quelconque des revendications 1 à 4, comportant une portion centrale (29) réalisée en un second matériau semiconducteur cristallin dopé de type n, identique au premier matériau semiconducteur cristallin, située au contact de la portion de détection (10) au niveau de la première face (22a), et participant à former la première région dopée (11).

6. Photodiode planaire (1) selon la revendication 5, comportant une couche supérieure isolante (23) recouvrant la portion de détection (10) au niveau de la première face (22a) ainsi que la portion intermédiaire périphérique (27), et entourant latéralement une partie de la portion centrale (29) qui fait saillie hors de la portion de détection (10).

7. Photodiode planaire (1) selon la revendication 5 ou 6, comportant une portion supérieure (32) située sur et au contact de la portion centrale (29), réalisée en un matériau semiconducteur cristallin dopé de type n.

8. Photodiode planaire (1) selon l'une quelconque des revendications 1 à 4, comportant une portion supérieure (32) située sur et au contact de la portion de détection (10), réalisée en un matériau semiconducteur cristallin dopé de type n.

9. Photodiode planaire (1) selon l'une quelconque des revendications 1 à 8, comportant des contacts métalliques (31.1, 31.2) destinés à assurer la polarisation électrique de la photodiode (1), dont au moins un contact métallique central (31.1) assurant la polarisation électrique de la première région dopée (11) et au moins un contact métallique latéral (31.2) venant au contact de la portion latérale périphérique (25).

10. Photodiode planaire (1) selon l'une quelconque des revendications 1 à 9, dans laquelle la portion de détection (10) est réalisée en germanium, et la portion latérale périphérique (25) est réalisée à base de silicium.

11. Procédé de fabrication d'au moins une photodiode (1) selon l'une quelconque des revendications précédentes, comportant les étapes suivantes :
o réalisation d'un empilement comportant une première sous-couche (22.1) destinée à former la deuxième région (12) et une deuxième sous-couche (22.2) destinée à former la région intermédiaire (13), recouvertes par une couche isolante supérieure (23) ;
o réalisation de la portion latérale périphérique (25) au travers de l'empilement pour déboucher sur la première sous-couche (22.1) ;
o réalisation d'une échancrure intermédiaire périphérique (26) dans la portion de détection (10) au travers de la couche isolante supérieure (23) et d'une partie de la deuxième sous-couche (22.2), entourant une zone destinée à former la première région dopée (11) ;
o réalisation de la portion intermédiaire périphérique (27), dans l'échancrure intermédiaire périphérique (26), par épitaxie à partir de la deuxième sous-couche (22.2).

12. Procédé de fabrication selon la revendication 11, comportant l'étape suivante, postérieure à la réalisation de la portion intermédiaire périphérique (27) :
o réalisation d'une échancrure centrale (28) dans la portion de détection (10) au travers de la couche isolante supérieure (23), entourée dans le plan principal par la portion intermédiaire périphérique (27) ;
o réalisation d'une portion centrale (29) réalisée en un second matériau semiconducteur cristallin identique au premier matériau semiconducteur cristallin, dans l'échancrure centrale (28), par épitaxie à partir de la deuxième sous-couche (22.2), et dopage de type n de la portion centrale (29) à la croissance, la portion centrale (29) participant ainsi à former la première région dopée (11).

13. Procédé de fabrication selon la revendication 12, dans laquelle l'échancrure centrale (28) présente une profondeur par rapport à un plan passant par la première face (22a) au plus égale à celle de l'échancrure intermédiaire périphérique (26).

14. Procédé de fabrication selon la revendication 11, comportant les étapes suivantes :
o réalisation d'une échancrure centrale (28) dans la portion de détection (10) au travers de la couche isolante supérieure (23) et d'une partie de la deuxième sous-couche (22.2), entourée dans le plan principal par la portion intermédiaire périphérique (27) ;
o réalisation d'une portion centrale (29) réalisée en un second matériau semiconducteur cristallin identique au premier matériau semiconducteur cristallin, dans l'échancrure centrale (28), par épitaxie à partir de la deuxième sous-couche (22.2), le second matériau semiconducteur cristallin étant non intentionnellement dopé ;
o réalisation d'une portion supérieure (32) sur et au contact de la portion centrale (29), en un matériau semiconducteur cristallin dopé de type n ;
o recuit de diffusion, de sorte que les dopants contenus dans la portion supérieure (32) diffusent au travers de la portion centrale (29) et dans une partie de la deuxième sous-couche (22.2) pour participer à former la première région dopée (11).

15. Procédé de fabrication selon la revendication 11, comportant les étapes suivantes :
o réalisation d'une portion supérieure (32) sur et au contact de la portion de détection (10), en un matériau semiconducteur cristallin dopé de type n ;
o recuit de diffusion, de sorte que les dopants contenus dans la portion supérieure (32) diffusent dans une partie de la deuxième sous-couche (22.2) pour former la première région dopée (11).

## Patentansprüche

1. Flächige Fotodiode (1), aufweisend:
eine Hauptschicht (22), die eine erste Fläche (22a) und eine zweite Fläche (22b) aufweist, die einander gegenüberliegen und parallel zu einer Hauptebene verlaufen, aus einem ersten kristallinen Halbleiterwerkstoff auf Basis von Germanium ausgeführt ist und einen Detektionsabschnitt (10) aufweist, der aus Folgendem gebildet ist:
einem ersten n-dotierten Bereich (11), der genau an der ersten Fläche (22a) anliegt und elektrisch polarisiert werden soll;
einem zweiten p-dotierten Bereich (12), der genau an der zweiten Fläche (22b) anliegt;
einem Zwischenbereich (13), der sich zwischen dem ersten dotierten Bereich (11) und dem zweiten dotierten Bereich (12) befindet und den ersten dotierten Bereich (11) in der Hauptebene umgibt;
einen seitlichen Umfangsabschnitt (25), der aus einem zweiten p-dotierten Halbleiterwerkstoff ausgeführt ist, den Detektionsabschnitt (10) in der Hauptebene umgibt, mit dem zweiten dotierten Bereich (12) in Kontakt kommt und elektrisch polarisiert werden soll;
**dadurch gekennzeichnet, dass** sie Folgendes aufweist:
einen Zwischenumfangsabschnitt (27), der abwechselnd aus monokristallinen Dünnschichten aus Silizium-Germanium (27.1) und Germanium (27.2) ausgeführt ist, den Detektionsabschnitt (10) im Bereich der ersten Fläche (22a) berührt und sich zwischen dem ersten dotierten Bereich (11) und dem seitlichen Umfangsabschnitt (25) in einem Abstand ungleich null derart erstreckt, dass er den ersten dotierten Bereich (11) in der Hauptebene umgibt.

2. Flächige Fotodiode (1) nach Anspruch 1, wobei die monokristallinen Dünnschichten aus Silizium-Germanium (27.1) einen Anteil in Atomprozent Silizium von mindestens 70% aufweisen.

3. Flächige Fotodiode (1) nach Anspruch 1 oder 2, wobei die monokristallinen Dünnschichten aus Silizium-Germanium (27.1) und Germanium (27.2) jeweils eine Dicke von kleiner gleich 4 nm aufweisen.

4. Flächige Fotodiode (1) nach einem der Ansprüche 1 bis 3, wobei sich der Zwischenumfangsabschnitt (27) in einem als Zwischenumfangsschlitz bezeichneten Schlitz (26) des Detektionsabschnitts (10) erstreckt, der sich im Bereich der ersten Fläche (22a) befindet.

5. Flächige Fotodiode (1) nach einem der Ansprüche 1 bis 4, die einen mittigen Abschnitt (29) aufweist, der aus einem zweiten n-dotierten kristallinen Halbleiterwerkstoff ausgeführt ist, der mit dem ersten kristallinen Halbleiterwerkstoff identisch ist, den Detektionsabschnitt (10) im Bereich der ersten Fläche (22a) berührt und an der Bildung des ersten dotierten Bereichs (11) beteiligt ist.

6. Flächige Fotodiode (1) nach Anspruch 5, die eine obere isolierende Schicht (23) aufweist, die den Detektionsabschnitt (10) im Bereich der ersten Fläche (22a) sowie dem Zwischenumfangsabschnitt (27) bedeckt und seitlich einen Teil des mittigen Abschnitts (29) umgibt, der aus dem Detektionsabschnitt (10) vorspringt.

7. Flächige Fotodiode (1) nach Anspruch 5 oder 6, die einen oberen Abschnitt (32) aufweist, der sich auf dem mittigen Abschnitt (29) befindet und ihn berührt und aus einem n-dotierten kristallinen Halbleiterwerkstoff ausgeführt ist.

8. Flächige Fotodiode (1) nach einem der Ansprüche 1 bis 4, die einen oberen Abschnitt (32) aufweist, der sich auf dem Detektionsabschnitt (10) befindet und ihn berührt und aus einem n-dotierten kristallinen Halbleiterwerkstoff ausgeführt ist.

9. Flächige Fotodiode (1) nach einem der Ansprüche 1 bis 8, die Metallkontakte (31.1, 31.2) aufweist, mit denen die elektrische Polarisation der Fotodiode (1) gewährleistet werden soll, wobei mindestens ein mittiger Metallkontakt (31.1) für die elektrische Polarisation des ersten dotierten Bereichs (11) sorgt und mindesten ein seitlicher Metallkontakt (31.2) den seitlichen Umfangsabschnitt (25) berührt.

10. Flächige Fotodiode (1) nach einem der Ansprüche 1 bis 9, wobei der Detektionsabschnitt (10) aus Germanium ausgeführt ist und der seitliche Umfangsabschnitt (25) auf Basis von Silizium ausgeführt ist.

11. Verfahren zur Herstellung von mindestens einer Fotodiode (1) nach einem der vorhergehenden Ansprüche, das folgende Schritte umfasst:
Fertigen eines Stapels, der eine erste Teilschicht (22.1), die den zweiten Bereich (12) bilden soll, und eine zweite Teilschicht (22.2) aufweist, die den Zwischenbereich (13) bilden soll, die mit einer oberen isolierenden Schicht (23) bedeckt sind;
Fertigen des seitlichen Umfangsabschnitts (25) durch den Stapel hindurch bis an die erste Teilschicht (22.1) heran;
Fertigen eines Zwischenumfangsschlitzes (26) im Detektionsabschnitt (10) durch die obere isolierende Schicht (23) und einen Teil der zweiten Teilschicht (22.2) hindurch, der einen Bereich umgibt, der den ersten dotierten Bereich (11) bilden soll;
Fertigen des Zwischenumfangsabschnitts (27) im Zwischenumfangsschlitz (26) mittels Epitaxie von der zweiten Teilschicht (22.2) aus.

12. Herstellungsverfahren nach Anspruch 11, das nach dem Fertigen des Zwischenumfangsabschnitts (27) folgenden Schritt umfasst:
Fertigen eines mittigen Schlitzes (28) im Detektionsabschnitt (10) durch die obere isolierende Schicht (23) hindurch, der in der Hauptebene vom Zwischenumfangsabschnitt (27) umgeben ist;
Fertigen eines mittigen Abschnitts (29), der aus einem zweiten kristallinen Halbleiterwerkstoff gefertigt ist, der mit dem ersten kristallinen Halbleiterwerkstoff identisch ist, im mittigen Schlitz (28) mittels Epitaxie von der zweiten Teilschicht (22.2) aus, und n-Dotieren des mittigen Abschnitts (29) während des Aufwachsens, womit der mittige Abschnitt (29) zur Bildung des ersten dotierten Bereichs (11) beiträgt.

13. Herstellungsverfahren nach Anspruch 12, wobei der mittige Schlitz (28) bezogen auf eine Ebene, die durch die erste Fläche (22a) verläuft, eine Tiefe aufweist, die höchstens der Tiefe des Zwischenumfangsschlitzes (26) entspricht.

14. Herstellungsverfahren nach Anspruch 11, das folgende Schritte umfasst:
Fertigen eines mittigen Schlitzes (28) im Detektionsabschnitt (10) durch die obere isolierende Schicht (23) und einen Teil der zweiten Teilschicht (22.2) hindurch, der in der Hauptebene vom Zwischenumfangsabschnitt (27) umgeben ist;
Fertigen eines mittigen Abschnitts (29), der aus einem zweiten kristallinen Halbleiterwerkstoff gefertigt ist, der mit dem ersten kristallinen Halbleiterwerkstoff identisch ist, im mittigen Schlitz (28) mittels Epitaxie von der zweiten Teilschicht (22.2) aus, wobei der zweite kristalline Halbleiterwerkstoff unbeabsichtigt dotiert ist;
Fertigen eines oberen Abschnitts (32) auf dem mittigen Abschnitt (29) und in Kontakt damit, aus einem n-dotierten kristallinen Halbleiterwerkstoff;
Diffusionsbehandeln, damit die in dem oberen Abschnitt (32) enthaltenen Dotierstoffe durch den mittigen Abschnitt (29) hindurch und in einen Teil der zweiten Teilschicht (22.2) hinein diffundieren und so zur Bildung des ersten dotierten Bereichs (11) beitragen.

15. Herstellungsverfahren nach Anspruch 11, das folgende Schritte umfasst:
Fertigen eines oberen Abschnitts (32) auf dem Detektionsabschnitt (10) und in Kontakt damit, aus einem n-dotierten kristallinen Halbleiterwerkstoff;
Diffusionsbehandeln, damit die in dem oberen Abschnitt (32) enthaltenen Dotierstoffe in einen Teil der zweiten Teilschicht (22.2) hinein diffundieren und so zur Bildung des ersten dotierten Bereichs (11) beitragen.

## Claims

1. Planar photodiode (1), comprising:
o a main layer (22) having a first face (22a) and a second face (22b) that are opposite one another and parallel to a main plane, made of a first crystalline semiconductor material based on germanium, comprising a detection portion (10) formed of:
• an n-doped first region (11) flush with the first face (22a), intended to be electrically biased;
• a p-doped second region (12) flush with the second face (22b);
• an intermediate region (13), located between the doped first region (11) and the doped second region (12) and surrounding the doped first region (11) in the main plane;
o a peripheral lateral portion (25), made of a p-doped second semiconductor material, surrounding the detection portion (10) in the main plane, and coming into contact with the doped second region (12), and intended to be electrically biased;
o **characterized in that** it comprises:
o a peripheral intermediate portion (27), made of an alternation of monocrystalline thin layers of silicon-germanium (27.1) and germanium (27.2), located in contact with the detection portion (10) on the first face (22a), and extending between and at a non-zero distance from the doped first region (11) and from the peripheral lateral portion (25) so as to surround the doped first region (11) in the main plane.

2. Planar photodiode (1) according to Claim 1, wherein the monocrystalline thin layers of silicon-germanium (27.1) comprise an atomic proportion of silicon at least equal to 70%.

3. Planar photodiode (1) according to Claim 1 or 2, wherein the monocrystalline thin layers of silicon-germanium (27.1) and germanium (27.2) each have a thickness less than or equal to 4 nm.

4. Planar photodiode (1) according to any one of Claims 1 to 3, wherein the peripheral intermediate portion (27) extends into a notch, called peripheral intermediate notch (26), of the detection portion (10) located on the first face (22a).

5. Planar photodiode (1) according to any one of Claims 1 to 4, comprising a central portion (29) made of an n-doped second crystalline semiconductor material, identical to the first crystalline semiconductor material, located in contact with the detection portion (10) on the first face (22a), and contributing to forming the doped first region (11).

6. Planar photodiode (1) according to Claim 5, comprising an upper insulating layer (23) covering the detection portion (10) on the first face (22a) and the peripheral intermediate portion (27), and laterally surrounding part of the central portion (29) that projects beyond the detection portion (10).

7. Planar photodiode (1) according to Claim 5 or 6, comprising an upper portion (32) located on and in contact with the central portion (29), made of an n-doped crystalline semiconductor material.

8. Planar photodiode (1) according to any one of Claims 1 to 4, comprising an upper portion (32) located on and in contact with the detection portion (10), made of an n-doped crystalline semiconductor material.

9. Planar photodiode (1) according to any one of Claims 1 to 8, comprising metal contacts (31.1, 31.2) intended to electrically bias the photodiode (1), including at least one central metal contact (31.1) electrically biasing the doped first region (11) and at least one lateral metal contact (31.2) coming into contact with the peripheral lateral portion (25).

10. Planar photodiode (1) according to any one of Claims 1 to 9, wherein the detection portion (10) is made of germanium, and the peripheral lateral portion (25) is based on silicon.

11. Process for fabricating at least one photodiode (1) according to any one of the preceding claims, comprising the following steps:
o producing a stack comprising a first sublayer (22.1) intended to form the second region (12) and a second sublayer (22.2) intended to form the intermediate region (13), both covered by an upper insulating layer (23);
o producing the peripheral lateral portion (25) through the stack so as to open out onto the first sublayer (22.1);
o producing a peripheral intermediate notch (26) in the detection portion (10) through the upper insulating layer (23) and part of the second sublayer (22.2), surrounding a zone intended to form the doped first region (11);
o producing the peripheral intermediate portion (27), in the peripheral intermediate notch (26), through epitaxy from the second sublayer (22.2).

12. Fabrication process according to Claim 11, comprising the following step, following the production of the peripheral intermediate portion (27):
o producing a central notch (28) in the detection portion (10) through the upper insulating layer (23), surrounded, in the main plane, by the peripheral intermediate portion (27);
o producing a central portion (29) made of a second crystalline semiconductor material identical to the first crystalline semiconductor material, in the central notch (28), through epitaxy from the second sublayer (22.2), and n-doping the central portion (29) during growth, the central portion (29) thus contributing to forming the doped first region (11).

13. Fabrication process according to Claim 12, wherein the central notch (28) has a depth with respect to a plane passing through the first face (22a) at most equal to that of the peripheral intermediate notch (26).

14. Fabrication process according to Claim 11, comprising the following steps:
o producing a central notch (28) in the detection portion (10) through the upper insulating layer (23) and part of the second sublayer (22.2), surrounded, in the main plane, by the peripheral intermediate portion (27);
o producing a central portion (29) made of a second crystalline semiconductor material identical to the first crystalline semiconductor material, in the central notch (28), through epitaxy from the second sublayer (22.2), the second crystalline semiconductor material being not intentionally doped;
o producing an upper portion (32) on and in contact with the central portion (29), made of an n-doped crystalline semiconductor material;
o diffusion annealing, such that the dopants contained in the upper portion (32) diffuse through the central portion (29) and into part of the second sublayer (22.2) so as to contribute to forming the doped first region (11).

15. Fabrication process according to Claim 11, comprising the following steps:
o producing an upper portion (32) on and in contact with the detection portion (10), made of an n-doped crystalline semiconductor material;
o diffusion annealing, such that the dopants contained in the upper portion (32) diffuse into part of the second sublayer (22.2) so as to form the doped first region (11).
